# EUROPEAN PATENT SPECIFICATION

(11) **EP 1 759 810 B1**
(45) Date of publication and mention of the grant of the patent: **07.10.2009**
(21) Application number: 06254557.9
(22) Date of filing: 31.08.2006
(51) Int. Cl.: B24B 37/04, B24B 41/06

(54) **Wafer polishing method**
Verfahren zum Polieren von Halbleiterscheiben
Méthode de polissage de plaquette

(30) Priority: 31.08.2005 JP 2005251026
(43) Date of publication of application: 07.03.2007
(73) Proprietor: Shin-Etsu Chemical Co., Ltd., Tokyo (JP)
(72) Inventor: Murai, Toshinari c/o Shin-Etsu Chemical Co., Ltd., Joetsu-shi, Niigata-ken (JP); Shibano, Yukio c/o Shin-Etsu Chemical Co., Ltd., Joetsu-shi, Niigata-ken (JP)
(74) Representative: Stoner, Gerard Patrick

(56) References cited:
- EP-A- 1 298 713
- JP-A- 62 297 064
- JP-A- 63 093 562
- US-A- 4 466 852
- US-A- 5 906 532

## Description

This invention relates to methods for mirror polishing wafers, typically lithium tantalate single crystal wafers for use in surface acoustic wave (often abbreviated as SAW) filters.

### BACKGROUND

In the mobile communications field including PHS and mobile phones, piezoelectric oxide single crystal wafers of lithium tantalate, lithium niobate, quartz, lithium tetraborate, langasite or the like are utilized as substrates of surface acoustic wave devices.

The SAW device includes a piezoelectric oxide single crystal wafer as a substrate and interdigital electrodes deposited on one major surface of the substrate to provide a transducer. Since the device is constructed such that the transducer receives and excites surface acoustic waves, the transducer-forming surface of the single crystal wafer must be mirror polished. If the back surface of the single crystal wafer is similarly mirror polished, the transducer receives and excites unnecessary waves (or interference waves) such as bulk waves at the same time as it receives and excites surface acoustic waves, incurring spurious disturbance in frequency response. Then, single crystal wafers for SAW devices are roughened on their back surface by lapping or honing with coarse abrasive grains.

Specifically, these wafers are traditionally fabricated as follows. A single crystal ingot is first prepared by art-recognized methods such as Czochralski method. Using an inner diameter slicing or wire saw, the ingot is cut into a disc-shaped wafer, which is lapped on both surfaces to a predetermined thickness. Then only one surface of the wafer is mirror polished by an abrasive tool, followed by cleaning.

In line with the recent trend that equipment such as PHS and mobile phones are reduced in size and profile, SAW devices built therein are also reduced in profile. There thus exists an urgent requirement to reduce the thickness of piezoelectric oxide single crystal wafers for use in SAW filters or the like.

In the case of lithium tantalate single crystal wafers for use in SAW filters or the like, for example, wafers of 350 microns thick are common at present while efforts have been initiated to produce thinner wafers with a thickness of around 250 microns.

In the SAW-utilizing devices described above, the necessary thickness of piezoelectric oxide single crystal is computed to be 10 times the wavelength in theory. This, combined with the state-of-the-art, suggests that a thickness of around 50 microns is sufficient. While piezoelectric oxide single crystal wafers having a thickness of 350 microns are supplied, some device manufacturers have started implementing a process of forming a metal electrode pattern on the mirror finish surface of such a thick wafer by photolithography or the like, and finally removing an unnecessary portion from the wafer back side by a surface grinding technique or the like.

Under such circumstances, if a wafer manufacturer supplies thinner piezoelectric oxide single crystal wafers, they are expected to contribute to a reduction of process steps on the device manufacturer side. However, as piezoelectric oxide single crystal wafers become thinner, they become lower in mechanical strength and more susceptible to failure during the wafer manufacturing process, so that the manufacturing yield can be reduced.

In particular, the process of working piezoelectric oxide single crystal wafers for use in SAW devices has the following problem. While a relatively thick disc-shaped wafer is furnished by cutting, it must be worked to the target thickness by post-steps of lapping and mirror polishing. An increased risk of wafer failure resulting from reduced mechanical strength is of concern.

As discussed above, when piezoelectric oxide single crystal wafers are used as SAW filters, the transducer-forming surface of the wafer must be mirror polished because the transducer receives and excites surface acoustic waves. On the other hand, the back surface of the wafer must be roughened by lapping or honing with coarse abrasive grains in order to exclude unnecessary waves (or interference waves) such as bulk waves which are received and excited at the same time as are surface acoustic waves.

Reference is made below to the following prior art documents: JP-A-58/129658, JP-A-2/098926, JP-A-62/297064, JP-A-63/093562.

US 5906532 describes a method for polishing semiconductor wafer substrates, in particular wafers carrying a deposited insulative layer (silicon oxide) which needs to be flattened because of irregularities caused by underlying aluminium interconnections, but also applicable to other materials such as PSG, BPSG, polysilicon, single-crystal silicon and metals. The wafer is polished while disposed between an abrasive cloth on a polishing platen and a substrate holder which has a substrate holder plate e.g. of quartz and a surrounding guide ring for the wafer. The wafer can be held against the plate initially by vacuum-chucking and then, during polishing, by feeding a flow of liquid (e.g. water) onto the plate side of the wafer substrate to form a flowing liquid layer which holds the wafer directly on the plate by surface tension, while relative rotation of the platen and holder effects polishing.

EP-A-1298713 describes the thinning of semiconductor wafers having a patterned oxide layer on a front surface. The patterned front surface is adhered to a support substrate, e.g. of glass, ceramic or semiconductor wafer, via a heat releasable adhesive layer. The back surface of the patterned wafer is ground to make it thinner, using e.g. a surface grinder with a rotary grinding stone and vacuum suction on a chuck table. The wafer and support substrate are then separated by heating.

### DISCLOSURE OF THE INVENTION

In the prior art process of working piezoelectric oxide single crystal wafers for use in SAW devices, an attempt to produce thin wafers which are as thin as 100 microns or less encounters the difficulty of producing such wafers in high yields because of reduced mechanical strength of thin wafers themselves.

In the process of working thin piezoelectric oxide single crystal wafers with a thickness of 100 microns or less for use in SAW devices, it is desired to produce in a consistent manner wafers having an improved working accuracy such as high flatness or parallelism equivalent to that of the existing thick piezoelectric oxide single crystal wafers with a thickness of about 350 microns, without the problem of reduced yields resulting from failure during lapping or mirror polishing due to lower mechanical strength of wafers themselves and while maintaining their front and back surface states equivalent to those of the existing thick piezoelectric oxide single crystal wafers with a thickness of about 350 microns.

Accordingly, an object of the present invention is to provide a method for polishing thin piezoelectric oxide single crystal wafers, especially having a thickness equal to or less than 100 µm, which method prevents the wafers from being broken during lapping or mirror polishing due to reduced mechanical strength, maintains the manufacturing yield equal to that of the existing 350-µm thick wafers, and ensures a working accuracy such as flatness or parallelism equivalent to that of the existing thick wafers.

The inventors have discovered that the following method is effective in the step of polishing a thin piezoelectric oxide single crystal wafer, especially having a thickness equal to or less than 100 µm, by lapping or mirror polishing, and that the mechanical strength of a piezoelectric oxide single crystal wafer can be increased by combining it with a support substrate.

In a first aspect (claim 1), the invention provides a method of polishing a piezoelectric oxide single crystal wafer substrate, having a diameter D mm, comprising the steps of:
laminating a support substrate, of the same material as the wafer substrate and having a diameter of from D mm to (D + 2.5) mm, to the wafer substrate to form a substrate laminate, the wafer and support substrates having polarised surfaces, and being laminated with their identically polarised surfaces in contiguous contact;
fitting the substrate laminate in a punched hole of a template secured to a plate, the punched hole having a diameter from D mm to (D + 5.0) mm, with the substrate between the plate and an abrasive cloth on a polishing platen;
relatively rotating said polishing platen and said plate to mirror-polish the cloth-side surface of the wafer substrate with the abrasive cloth, and
feeding a liquid onto the plate-side surface of the substrate laminate so that it is directly held to the plate by the adsorption force of the liquid, while performing the mirror polishing.

In a second aspect (claim 2), the invention provides a method of polishing a piezoelectric oxide single crystal wafer substrate, having a diameter D mm, comprising the steps of:
laminating a support substrate, of the same material as the wafer substrate and having a diameter from D mm to (D + 2.5) mm, to the wafer substrate to form a substrate laminate, the wafer and support substrates having polarised surfaces, and being laminated with their identically polarised surfaces in contiguous contact;
fitting the substrate laminate within a punched hole of a polishing carrier, the punched hole of the carrier having a diameter of from D mm to (D + 5.0) mm and the polishing carrier being disposed between abrasive cloths on a pair of upper and lower polishing platens, and
relatively rotating the polishing platens to mirror-polish the outer surfaces of the wafer substrate and the support substrate in the laminate.

The wafer comprises a piezoelectric oxide single crystal, which is preferably lithium tantalate. Typically a lithium tantalate single crystal wafer has a thickness of up to 100 µm.

### BENEFITS

The method of polishing wafer substrates, specifically piezoelectric oxide single crystal wafers according to the invention is successful in producing in a consistent manner wafers with a thickness equal to or less than 100 µm having an improved working accuracy such as high flatness or parallelism equivalent to that of the existing thick piezoelectric oxide single crystal wafers with a thickness of about 350 microns. The invention overcomes the problem of reduced yields resulting from failure during lapping or mirror polishing due to lower mechanical strength of wafers themselves. The resulting wafers maintain their front and back surface states equivalent to those of the existing thick piezoelectric oxide single crystal wafers with a thickness of about 350 microns. When the piezoelectric oxide single crystal wafers are used in devices, they contribute to a reduction of steps in a device manufacturing process because the step of finally machining an unnecessary portion off from the wafer back side by a surface grinding technique or the like can be eliminated.

### BRIEF DESCRIPTION OF THE DRAWINGS

FIG. 1 schematically illustrates a single-side polishing apparatus used in one embodiment of the invention.
FIG. 2 schematically illustrates a double-side polishing apparatus used in another embodiment of the invention.
FIG. 3 schematically illustrates a single-side polishing apparatus used in a prior art wafer manufacturing method.

### DESCRIPTION OF THE PREFERRED EMBODIMENTS

One embodiment of the invention is a method for polishing a wafer substrate, comprising the steps of disposing the wafer substrate between an abrasive cloth on a polishing platen and a plate, and relatively rotating the polishing platen and the plate for mirror polishing the abrasive cloth side surface of the wafer substrate with the abrasive cloth. A liquid is fed onto the plate side surface of the wafer substrate. Then the wafer substrate is directly held to the plate by the adsorption force of the liquid while performing the mirror polishing.

Another embodiment of the method for polishing a wafer substrate, comprises the steps of disposing the wafer substrate between abrasive cloths on a pair of upper and lower polishing platens, and relatively rotating the polishing platens for mirror polishing the front and back surfaces of the wafer substrate. Provided that the wafer substrate has a diameter of D mm, a polishing carrier having a punched hole having a diameter from D mm to D+5.0 mm is used.

The method can polish a wafer whose back surface has been roughened. That is, the mirror polishing step is performed following the step of roughening the back surface of the wafer substrate. Preferably the wafer substrate (product substrate) and the support substrate are combined or laminated with a wax, pressure-sensitive adhesive or the like to form the substrate laminate. The substrate laminate on its support substrate side is directly held by the plate via the liquid.

The wafer must be held and secured to the plate at any desired position. To this end, a template with a punched hole having a diameter from an identical diameter (identical to the diameter of the substrate laminate) to the identical diameter plus 5.0 mm (that is, from D mm to D+5.0 mm), more preferably a diameter from the identical diameter to the identical diameter plus 2.5 mm, is secured to the plate. The substrate laminate is fitted within the punched hole of the template and in this state, the substrate laminate is directly held by the plate via the liquid.

Also the method can polish a piezoelectric oxide single crystal wafer whose back surface has been roughened. That is, the mirror polishing step is performed following the step of roughening the back surface of the wafer substrate. Preferably the wafer substrate (product substrate) and the support substrate are combined or laminated with a wax, pressure-sensitive adhesive or the like to form the substrate laminate. The substrate laminate is disposed between abrasive cloths on a pair of upper and lower polishing platens. The polishing platens are relatively rotated for mirror polishing the upper and lower surfaces of the substrate laminate with the abrasive cloths.

In one preferred embodiment of the wafer polishing method of the invention, the substrate laminate disposed between abrasive cloths on a pair of upper and lower polishing platens is subjected to planetary motion. To this end, preferably a polishing carrier with the punched hole having a diameter from an identical diameter (identical to the diameter of the substrate laminate) to the identical diameter plus 5.0 mm (that is, from D mm to D+5.0 mm), more preferably a diameter from the identical diameter to the identical diameter plus 2.5 mm, is used.

The support substrate used herein has a diameter identical to or more than the diameter of the wafer substrate (product substrate). When the number of support substrates loaded on the polishing apparatus is considered, the support substrate should have a diameter from the identical diameter (identical to the diameter of the wafer substrate) to the identical diameter plus 2.5 mm, more preferably a diameter from the identical diameter to the identical diameter plus 1.0 mm. No particular limit is imposed on the thickness of the support substrate. When the mechanical strength of the substrate laminate is considered, the support substrate should preferably be thick enough and may typically be formed to a thickness of 0.1 to 30 mm.

The support substrate has a coefficient of thermal expansion and a thermal expansion behavior similar to the wafer substrate because the wafer substrate can warp when heat treatment is involved in the laminating step. The support substrate and the wafer substrate are laminated so that they develop thermal expansion behavior in opposite directions. Specifically, a support substrate of the same material as the wafer substrate (product substrate) is furnished, and the substrates are laminated with their identically polarized surfaces in contiguous contact. This lamination offsets the warpage of the substrates.

In the situation wherein a support substrate of the same material as the wafer substrate (product substrate) is furnished, and the substrates are laminated with their identically polarized surfaces in contiguous contact so as to offset the warpage of the substrates, the substrate laminate can be polished by a single-side polishing technique whereupon the polished wafer substrate is ready for use as a product substrate. Alternatively, the substrate laminate can be polished by a double-side polishing technique whereupon both the polished wafer and support substrates are ready for use as product substrates.

The lamination of a support substrate to a thin wafer substrate having a thickness equal to or less than 100 µm compensates for a lowering of mechanical strength of the thin wafer substrate and thus avoids a reduction of manufacture yield by failure during the mirror polishing. A choice of wax or pressure-sensitive adhesive between the wafer and support substrates ensures to achieve a working precision such as flatness or parallelism equal to that of the existing 350-µm thick wafers.

It is possible to produce a thin wafer having a thickness equal to or less than 100 µm by cutting an ingot into a relatively thick disc-shaped wafer, lapping the wafer to a thickness equal to that of the existing 350-µm thick wafers, then performing the laminating and polishing steps as described above. Alternatively, the relatively thick disc-shaped wafer as cut, with its surface to be finally mirror polished being inside, is laminated to a support substrate with wax or pressure-sensitive adhesive and then lapped, whereby the wafer back surface is worked to a surface roughness for device characteristics. Thereafter, the wafer substrate (product substrate) is separated from the support substrate, and the wafer substrate, with its roughened back surface being inside, is laminated again to a support substrate with wax or pressure-sensitive adhesive and then mirror polished, whereby the front and back surfaces of the wafer are finally worked to the desired states.

The lamination of a wafer substrate (product substrate) to a support substrate followed by lapping and mirror polishing ensures that wafers with a thickness equal to or less than 100 µm are produced in a consistent manner at an improved working accuracy such as high flatness or parallelism equivalent to that of the existing thick piezoelectric oxide single crystal wafers with a thickness of about 350 microns, while avoiding the problem of reduced yields resulting from failure during lapping or mirror polishing due to lower mechanical strength of thin wafers themselves and while maintaining their front and back surface states equivalent to those of the existing thick piezoelectric oxide single crystal wafers with a thickness of about 350 microns.

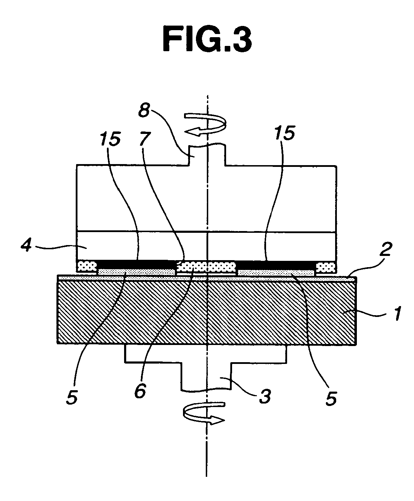

Referring to the drawings, the inventive method is described in further detail. Before describing the inventive method, reference is made to FIG. 3 that illustrates an exemplary single-side polishing apparatus used in a prior art wafer manufacturing method. The apparatus includes a polishing platen 1 and an abrasive cloth 2 attached to the surface of the platen 1 to provide a polishing surface. A drive shaft 3 is secured to the lower side of the polishing platen 1. Then, the polishing platen 1 is driven for rotation at any desired rotational speed by a drive system (e.g., motor), not shown, through the shaft 3.

Disposed on the polishing platen 1 (exactly on the abrasive cloth 2) are wafers 5, which are held by a plate 4, for example, a ceramic plate. The wafers 5 are piezoelectric oxide single crystal wafers. A variety of means have been proposed for mounting the wafers 5 on the plate 4. For example, the wafers 5 may be adhesively secured to the plate 4 using wax, as described in JU-A 58-129658. Also, a portion of the plate 4 corresponding to the wafers may be provided with a number of suction holes so that the wafers 5 are attracted to the plate 4 by vacuum suction, as described in JP-A 2-98926. Moreover, backings or back pads 15 comprising an adsorbent of polyurethane foam or the like may be secured to the plate 4 using double-side adhesive tape or the like, whereby the wafers 5 are held on the adsorbent through water adsorption, as described in JP-A 62-297064 and JP-A 63-93562. In FIG. 3, numeral 6 is a template and numeral 8 is a drive shaft.

Among these, the technique of adhesively holding wafers directly on a plate via wax is good in working accuracy such as flatness or parallelism, but requires adhesive attachment. When applied to thin wafers with a thickness equal to or less than 100 µm, this adhesive technique raises from the mechanical strength standpoint a problem that the wafers can be broken in subsequently separating from the plate.

The technique of holding wafers directly on a plate by vacuum suction is good in working accuracy such as flatness or parallelism, but has the increased risk that if foreign particles are present between the wafers and the plate, the corresponding portions of the wafers are excessively polished to form dimples. Such dimples become significant particularly when wafers are as thin as 100 µm or less. It is then necessary to prevent foreign particles from being incorporated, which requires strict management of a clean level and automation to minimize man handling, and hence, a vast capital investment therefor.

The technique of suction holding wafers using back pads is free from deficiencies as described above. By changing the thickness of the template, even those wafers which are as thin as 100 µm or less can be polished. However, a varying thickness of the adsorbent made of polyurethane foam can result in polished wafers with reduced working accuracy such as flatness or parallelism. In addition, edge rounding often occurs at the wafer periphery.

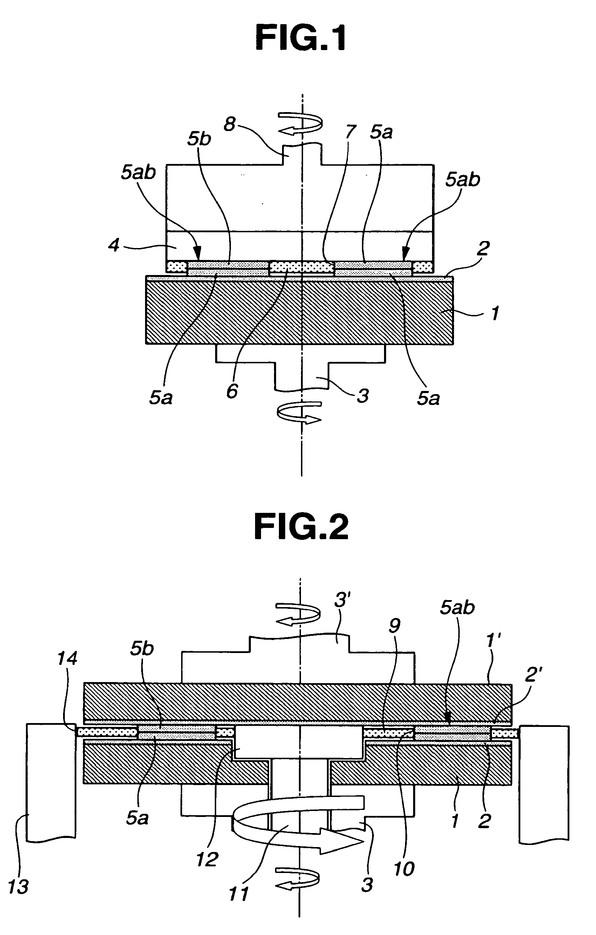

Under the above-discussed circumstances, the inventors adopt a technique of holding wafers directly to a plate via a liquid, that is, by the adsorption force of liquid. Referring to FIG. 1, an exemplary single-side polishing apparatus is shown for illustrating the method of polishing thin wafers, typically having a thickness equal to or less than 100 µm. The polishing procedure and mechanism are substantially the same as in FIG. 3. The method starts with wafers (product substrates) 5a whose back surface has been roughened. The wafer 5a with its back surface inside is combined or laminated to a support substrate 5b having a diameter identical to the wafer 5a via wax or pressure-sensitive adhesive to form a substrate laminate 5ab. These substrate laminates 5ab are subjected to single-side polishing as are the wafers 5 shown in FIG. 3. As a result, only one surface of wafers (product substrates) 5a is mirror polished.

More particularly, before wafers 5 are mounted to the plate 4, a template 6 of glass-reinforced epoxy having punched holes is secured to the plate 4 with double-side adhesive tape or the like, to define on the plate 4 recesses 7 for holding wafers therein. A liquid such as water is applied to the recesses (punched holes) 7 whereby the wafers 5 are held within the recesses 7 via the liquid, i.e., by the adsorption force of liquid. This holding technique allows the wafers 5 to rotate freely within the recesses 7 in the plate 4 (serving as the wafer holding position) during the mirror-polishing operation, leaving the risk that the wafer back surface is rubbed and flawed. So, as shown in FIG. 1, the wafer (product substrate) 5a is laminated to a support substrate 5b via wax or pressure-sensitive adhesive to form a substrate laminate 5ab. The support substrate side surface of the substrate laminate 5ab is held to the plate 4 via a liquid such as water, that is, by the adsorption force of liquid. Then, the polishing operation does not cause rubbing flaws on the back surface of the wafer (product substrate) 5a although the support substrate 5b is rubbed and flawed. In addition, thin piezoelectric oxide single crystal wafers (product substrates) 5a having a thickness equal to or less than 100 µm can be advantageously produced.

In these embodiments, only one surface of a wafer 5, that is, the surface in sliding contact with the abrasive cloth 2 is subjected to mirror polishing. Specifically, the plate 4 having wafers 5 held thereon is driven for rotation by another drive system, not shown, through a drive shaft 8. Abrasives are fed to the abrasive cloth 2 from an abrasive supply, not shown. While feeding abrasives and rotating a polishing platen 1, the plate 4 that forces the wafers 5 against the abrasive cloth 2 is rotated counter to the platen 1. In this way, the surface (in sliding contact with the abrasive cloth 2) of the wafers 5 is mirror polished.

After the completion of mirror polishing, the substrate laminate 5ab is separated into the wafer (product substrate) 5a and the support substrate 5b. Since the support substrate 5b remains unchanged in thickness, it can be used again as a support substrate. The support substrate 5b is of the same material as the wafer (product substrate) 5a, so the subsequent mirror-polishing operation can use that support substrate as a wafer (product substrate) 5a whereby the substrate is mirror polished.

FIG. 2 shows an exemplary double-side polishing apparatus for illustrating the method of polishing thin piezoelectric oxide single crystal wafers, having a thickness equal to or less than 100 µm. The apparatus includes a pair of lower and upper polishing platens 1 and 1', which are opposed to each other. Abrasive cloths 2 and 2' are attached to the opposed surfaces of the platens 1 and 1', respectively, to present polishing surfaces. Drive shafts 3, 3' are secured to the polishing platens 1, 1', respectively. The polishing platens 1, 1' are rotated in the same or opposite directions at any desired rotational speeds by drive systems (e.g., motors), not shown, via the shafts 3, 3'.

Disposed between the pair of lower and upper platens 1 and 1' (exactly between the abrasive cloths 2 and 2') is a polishing carrier 9 having a hole 10 for receiving therein a substrate laminate 5ab each consisting of a wafer (product substrate) 5a and a support substrate 5b. The carrier 9 at the periphery has a planetary gear in mesh engagement with a sun gear 12 of a central drive shaft 11 and an internal gear 14 of an external member 13, so that when the drive shaft 11 is driven for rotation, the carrier 9 undergoes planetary motion around the drive shaft 11. Again, abrasives are fed to between the abrasive cloths 2 and 2' from an abrasive supply, not shown.

With this construction, the pair of lower and upper platens 1 and 1' apply a predetermined pressure against the substrate laminate 5ab fitted in the hole 10 of the polishing carrier 9, and abrasives are fed, and the lower and upper platens 1 and 1' are relatively rotated, and the polishing carrier 9 having the substrate laminate 5ab arranged therein is given planetary motion. In this way, one surface (in sliding contact with the abrasive cloth 2) of the wafer (product substrate) 5a and one surface (in sliding contact with the abrasive cloth 2') of the support substrate 5b are mirror polished.

During the separation step following the mirror polishing step, the substrate laminate 5ab is separated into the wafer (product substrate) 5a and the support substrate 5b. The support substrate 5b has a reduced thickness since it has been mirror polished on its one surface. It cannot be reused if its reduced thickness is not enough to compensate for a shortage of mechanical strength of a wafer (product substrate) 5a. Otherwise, it can be reused as a support substrate. The support substrate 5b is of the same material as the wafer (product substrate) 5a and laminated to the wafer 5a with their identical polarized surfaces mated, so the support substrate 5b can be regarded and processed as the same product substrate as the wafer (product substrate) 5a.

Now a technique as described in JP-A 11-309665 is considered. In this case, two wafers 5 are laminated via an adsorbent plate to form a sandwich, the sandwich is disposed within a hole 10 of a polishing carrier 9, and the outer surfaces (in sliding contact with abrasive cloths 2, 2') of the two wafers 5 are mirror polished. Since the two wafers are not firmly joined together, they can be rubbed each other. Concerns rise that the inner (or back) surfaces of the wafers are flawed. Since the mechanical strength of wafers is not augmented, this technique is inadequate for the manufacture of thin wafers having a thickness equal to or less than 100 µm.

Next, a process of manufacturing wafers according to embodiments of the invention using single- or double-side polishing apparatus as shown above is described. A single crystal ingot is first prepared by Czochralski method, for example. The ingot is then sliced into disc-shaped wafers. Using a double-side lapping machine, the wafers as sliced are lapped on both surfaces to a desired thickness. The slicing and lapping steps may be conducted as in the prior art.

Then the wafer (product substrate) 5a which has been lapped, that is, roughened on both front and back surfaces, with its back surface inside, is laminated to a support substrate 5b via wax, pressure-sensitive adhesive or the like. At this point, the support substrate 5b should have a diameter from an identical diameter (identical to the diameter D in millimeter of the wafer) to the identical diameter plus 2.5 mm (that is, from D mm to D+2.5 mm), preferably a diameter from the identical diameter to the identical diameter plus 1.0 mm (that is, from D mm to D+1.0 mm).

When the number of support substrates loaded on the polishing apparatus is considered, the support substrate 5b should preferably have an identical diameter to the wafer (product substrate) 5a. No particular limit is imposed on the thickness of the support substrate. When the mechanical strength of the substrate laminate is considered, the support substrate 5b should preferably be thick enough.

The support substrate 5b is made having a coefficient of thermal expansion and a thermal expansion behavior similar to the wafer (product substrate) 5a because the wafer 5a can warp when heat treatment is involved in the laminating step. The support substrate and the wafer are laminated to form a substrate laminate 5ab so that they develop thermal expansion behavior in opposite directions. Specifically, a support substrate 5b of the same material as a wafer (product substrate) 5a is furnished, and the substrates 5a and 5b are preferably laminated with their identically polarized surfaces in contiguous contact. This lamination offsets the warpage of the substrates.

In one embodiment, the substrate laminate 5ab is then mirror polished using the single-side polishing apparatus shown in FIG. 1. In the mirror polishing step, the substrate laminate 5ab is first mounted to the plate 4 so that the support substrate 5b contacts the plate 4.

The plate 4 having the substrate laminate 5ab mounted thereon is placed above the polishing platen 1 such that the surface to be polished is in contiguous contact with the abrasive cloth 2. The rotating shaft 8 is slowly moved downward until it comes into tight contact with the plate 4. While abrasives are fed onto the platen 1, the plate 4 and the polishing platen 1 are driven for rotation. In this way, the surface (in sliding contact with the abrasive cloth 2) of the wafer (product substrate) 5a is mirror polished.

In this regard, since the wafer (product substrate) 5a which is as thin as 100 µm or less is laminated to the support substrate 5b via wax or pressure-sensitive adhesive, the lamination compensates for a loss of mechanical strength of the wafer (product substrate) 5a due to a thickness reduction, allowing the thin wafer to be mirror polished as are the existing 350 µm thick wafers.

In another embodiment, the substrate laminate 5ab is mirror polished using the double-side polishing apparatus shown in FIG. 2. In the mirror polishing step, the substrate laminate 5ab is first fitted within the hole 10 of the carrier 9.

Then the polishing carrier 9 having the substrate laminate 5ab fitted therein is disposed between a pair of lower and upper polishing platens 1 and 1' so that the surfaces to be polished are in contiguous contact with the abrasive cloths 2 and 2'. A predetermined pressure is applied by the pair of lower and upper polishing platens 1 and 1', and abrasives are fed between the abrasive cloths 2 and 2'. In this state, the lower and upper polishing platens 1 and 1' are relatively rotated, and the polishing carrier 9 having the substrate laminate 5ab fitted therein is given planetary motion, whereby the surface (in sliding contact with the abrasive cloth 2) of the wafer (product substrate) 5a and the surface (in sliding contact with the abrasive cloth 2') of the support substrate 5b are mirror polished.

In this regard, since the wafer (product substrate) 5a which is as thin as 100 µm or less is laminated to the support substrate 5b via wax or pressure-sensitive adhesive, the lamination compensates for a loss of mechanical strength of the wafer (product substrate) 5a due to a thickness reduction, allowing the thin wafer to be mirror polished as are the existing 350 µm thick wafers.

The support substrate 5b is of the same material as a wafer (product substrate) 5a and laminated to the wafer 5a with their identical polarized surfaces mated, so the support substrate 5b can be regarded and processed as the same product substrate as the wafer (product substrate) 5a.

After the completion of mirror polishing, the substrate laminate 5ab is separated into the wafer (product substrate) 5a and the support substrate 5b. Since the wafer (product substrate) 5a has a back surface which has not been worked and a front surface which has been mirror polished as are the existing 350-µm thick wafers, it maintains the same front and back surface states as the existing 350-µm thick wafers and possesses an excellent working accuracy such as a high flatness or parallelism comparable to the existing 350-µm thick wafers.

As described above, according to the embodiments of the wafer manufacturing method, even wafers which are as thin as 100 µm or less and hence low in mechanical strength can be lapped or mirror polished without problems associated with low mechanical strength such as breakage during the lapping or mirror polishing operation and a concomitant reduction of manufacturing yield. Wafers possessing an excellent working accuracy such as a high flatness or parallelism can be produced in a consistent manner while maintaining the same front and back surface states as the existing 350-µm thick wafers. The invention greatly contributes to improvements in manufacturing yield and efficiency of SAW devices which are required of size reduction and thus use wafers as thin as 100 µm or less. According to the invention, thin wafers having a thickness down to about 50 µm can be polished.

### EXAMPLES

Examples are given below by way of illustration and not by way of limitation.

### Example 1

This example relates to a lithium tantalate (LiTaO₃) single crystal wafer having a diameter of 100 mm (4 inches). A single crystal ingot was grown by Czochralski method and sliced into wafers using a wire saw. The wafers as sliced were lapped on a double-side lapping machine with appropriate abrasives (loose abrasive grains) to a desired thickness and until the front and back surfaces reached the predetermined roughness state.

Then two wafers lapped as above (having front and back surfaces roughened) were laminated together, with their back surfaces (identical polarized surfaces) inside, using a wax Skyliquid TW-2511 (Nikka Seiko Co., Ltd.). Although a heat treatment is involved in the lamination step, this lamination ensures that the warpage of two wafers is offset because two wafers of the same material develop thermal expansion behavior in opposite directions. The laminate was ready for the subsequent polishing step.

Then the substrate laminate 5ab was mirror polished using a single-side polishing apparatus as shown in FIG. 1. Specifically, a template 6 of glass-reinforced epoxy resin having holes (diameter 100.8 mm) punched out was secured to a ceramic plate 4 with double-side adhesive tape to define on the plate 4 recesses (punched holes) 7 for receiving wafers in place. The substrate laminate 5ab was fitted in the recess 7 to which water was applied whereby the substrate 5b side was held to the plate 4 by the surface tension of water. In this state, the plate 4 was placed on a platen 1 such that the surface to be polished was in contiguous contact with an abrasive cloth 2. Then a drive shaft 8 was slowly moved down until it came in contact with the plate 4. While abrasives of colloidal silica were fed onto the abrasive cloth 2, the shaft 8 was further moved down to apply some pressure and rotated slowly. The subsequent rotation at the predetermined rotational speed under the predetermined pressure achieved mirror polishing.

After the completion of mirror polishing, the substrate laminate 5ab was taken out of the recess 7 in the ceramic plate 4 and separated through heat treatment into two wafers, wafer (product substrate) 5a and support substrate 5b. The wafers were ultrasonic cleaned at a certain frequency in a selected chemical solution for removing the abrasives of colloidal silica, particles and wax from the wafer surface.

After cleaning, the thickness of these wafers, wafer (product substrate) 5a and support substrate 5b was measured by a probe thickness gauge, finding that the wafer (product substrate) 5a was finished to a thickness of 90-100 µm, and the thickness of support substrate 5b remained unchanged from before charging on the polishing apparatus. The back surfaces of these wafers, wafer (product substrate) 5a and support substrate 5b were visually observed under fluorescent lamps, finding no scratches. In the subsequent batch, the wafer used as the support substrate 5b, having no scratches on the back surface, was made wafer (product substrate) and mirror polished similarly.

By repeating the above-described procedure, 100 wafers were polished. The wafers (product substrates) 5a were measured for flatness, finding a total thickness variation (TTV) of 0.85 to 2.53 µm and a local thickness variation maximum (LTVₘₐₓ) of 0.24 to 0.41 µm at 5 mm × 5 mm site. No breakage occurred in the wafers during the single-side polishing operation, but breakage occurred in some wafers when the substrate laminate was separated into two wafers after the mirror polishing. The manufacturing yield was 97%.

### Example 2

This example relates to a lithium tantalate (LiTaO₃) single crystal wafer having a diameter of 100 mm (4 inches). A single crystal ingot was grown by Czochralski method and sliced into wafers using a wire saw. The wafers as sliced were lapped on a double-side lapping machine with appropriate abrasives (loose abrasive grains) to a desired thickness and until the front and back surfaces reached the predetermined roughness state.

Then two wafers lapped as above (having front and back surfaces roughened) were laminated together, with their front surfaces (identical polarized surfaces) inside, using a wax Skyliquid TW-2511 (Nikka Seiko Co., Ltd.). Although a heat treatment is involved in the lamination step, this lamination ensures that the warpage of two wafers is offset because two wafers of the same material develop thermal expansion behavior in opposite directions. The laminate was ready for the subsequent lapping step.

Using a double-side lapping machine and adequate abrasives (loose abrasive grains), the substrate laminate was lapped on the double sides to the desired thickness.

After the completion of double-side lapping, the substrate laminate 5ab was separated through heat treatment into two wafers. The wafers were ultrasonic cleaned in a selected chemical solution for removing the abrasives, particles and wax from the wafer surface.

After cleaning, the thickness of these wafers was measured by a probe thickness gauge, finding that the wafers were finished to a thickness of 120-130 µm, which was appropriate to work on the single-side polishing apparatus.

With the above results borne in mind, there were furnished a wafer (product substrate) 5a which was twice lapped to a thickness of 120-130 µm as described above, and a support substrate 5b which was obtained by double-side lapping a sliced wafer to the desired thickness. These two wafers were laminated together, with their back surfaces (identical polarized surfaces) inside, using a wax Skyliquid TW-2511 (Nikka Seiko Co., Ltd.). Although a heat treatment is involved in the lamination step, this lamination ensures that the warpage of two wafers is offset because two wafers of the same material develop thermal expansion behavior in opposite directions. The laminate was ready for the subsequent polishing step.

Then the substrate laminate 5ab was mirror polished using a single-side polishing apparatus as shown in FIG. 1. Specifically, a template 6 of glass-reinforced epoxy resin having holes (diameter 100.8 mm) punched out was secured to a ceramic plate 4 with double-side adhesive tape to define on the plate 4 recesses (punched holes) 7 for receiving wafers in place. The substrate laminate 5ab was fitted in the recess 7 to which water was applied whereby the substrate 5b side was held to the plate 4 by the surface tension of water. In this state, the plate 4 was placed on a platen 1 such that the surface to be polished was in contiguous contact with an abrasive cloth 2. Then a drive shaft 8 was slowly moved down until it came in contact with the plate 4. While abrasives of colloidal silica were fed onto the abrasive cloth 2, the shaft 8 was further moved down to apply some pressure and rotated slowly. The subsequent rotation at the predetermined rotational speed under the predetermined pressure achieved mirror polishing.

After the completion of mirror polishing, the substrate laminate 5ab was taken out of the recess 7 in the ceramic plate 4 and separated through heat treatment into two wafers, wafer (product substrate) 5a and support substrate 5b. The wafers were ultrasonic cleaned at a certain frequency in a selected chemical solution for removing the abrasives of colloidal silica, particles and wax from the wafer surface.

After cleaning, the thickness of these wafers, wafer (product substrate) 5a and support substrate 5b was measured by a probe thickness gauge, finding that the wafer (product substrate) 5a was finished to a thickness of 90-100 µm, and the thickness of support substrate 5b remained unchanged from before charging on the polishing apparatus. The back surfaces of these wafers, wafer (product substrate) 5a and support substrate 5b were visually observed under fluorescent lamps, finding no scratches. Since the wafer used as the support substrate 5b had no scratches on the back surface, but a substantial thickness, it was reused as a support substrate in the subsequent batch.

By repeating the above-described procedure, 100 wafers were polished. The wafers (product substrates) 5a were measured for flatness, finding a total thickness variation (TTV) of 0.76 to 2.85 µm and a local thickness variation maximum (LTVₘₐₓ) of 0.22 to 0.45 µm at 5 mm × 5 mm site. No breakage occurred in the wafers during the single-side polishing operation, and no breakage occurred in the wafers when the substrate laminate was separated into two wafers after the mirror polishing. The manufacturing yield was thus 100%.

### Example 3

This example relates to a lithium tantalate (LiTaO₃) single crystal wafer having a diameter of 100 mm (4 inches). A single crystal ingot was grown by Czochralski method and sliced into wafers using a wire saw. The wafers as sliced were lapped on a double-side lapping machine with appropriate abrasives (loose abrasive grains) to a desired thickness and until the front and back surfaces reached the predetermined roughness state.

Then two wafers lapped as above (having front and back surfaces roughened) were laminated together, with their back surfaces (identical polarized surfaces) inside, using a wax Skyliquid TW-2511 (Nikka Seiko Co., Ltd.). Although a heat treatment is involved in the lamination step, this lamination ensures that the warpage of two wafers is offset because two wafers of the same material develop thermal expansion behavior in opposite directions. The laminate was ready for the subsequent polishing step.

Then the substrate laminate 5ab was mirror polished using a double-side polishing apparatus as shown in FIG. 2. Specifically, the substrate laminate 5ab was fitted in a hole (diameter 100.8 mm) of a polishing carrier 9. The carrier 9 having the substrate laminate 5ab received therein was disposed between a pair of lower and upper polishing platens 1 and 1' such that the surfaces to be polished were in contiguous contact with the abrasive cloths 2 and 2'. The lower and upper polishing platens 1 and 1' were then moved closer to apply a predetermined pressure. While abrasives of colloidal silica were fed to between the abrasive cloths 2 and 2', the platens 1 and 1' were rotated relatively. The polishing carrier 9 having the substrate laminate 5ab received therein was given planetary motion, thereby mirror polishing the laminate.

After the completion of mirror polishing, the substrate laminate 5ab was taken out of the hole 10 in the polishing carrier 9 and separated through heat treatment into two wafers, wafer (product substrate) 5a and support substrate 5b. The wafers were ultrasonic cleaned at a certain frequency in a selected chemical solution for removing the abrasives of colloidal silica, particles and wax from the wafer surface.

After cleaning, the thickness of these wafers, wafer (product substrate) 5a and support substrate 5b was measured by a probe thickness gauge, finding that both wafer (product substrate) 5a and support substrate 5b were finished to a thickness of 90-100 µm. The back surfaces of these wafers, wafer (product substrate) 5a and support substrate 5b were visually observed under fluorescent lamps, finding no scratches. It is noted that since the wafer used as the support substrate 5b had been finished to a quality level comparable to the wafer (product substrate) 5a, it was equally handled as a product substrate.

By repeating the above-described procedure, 200 wafers were polished. The wafers (product substrates) 5a were measured for flatness, finding a total thickness variation (TTV) of 0.72 to 2.02 µm and a local thickness variation maximum (LTVₘₐₓ) of 0.18 to 0.37 µm at 5 mm × 5 mm site. No breakage occurred in the wafers during the double-side polishing operation, but breakage occurred in some wafers when the substrate laminate was separated into two wafers after the mirror polishing. The manufacturing yield was 98%.

### Example 4

This example relates to a lithium tantalate (LiTaO₃) single crystal wafer having a diameter of 100 mm (4 inches). A single crystal ingot was grown by Czochralski method and sliced into wafers using a wire saw. The wafers as sliced were lapped on a double-side lapping machine with appropriate abrasives (loose abrasive grains) to a desired thickness and until the front and back surfaces reached the predetermined roughness state.

Then two wafers lapped as above (having front and back surfaces roughened) were laminated together, with their front surfaces (identical polarized surfaces) inside, using a wax Skyliquid TW-2511 (Nikka Seiko Co., Ltd.). Although a heat treatment is involved in the lamination step, this lamination ensures that the warpage of two wafers is offset because two wafers of the same material develop thermal expansion behavior in opposite directions. The laminate was ready for the subsequent lapping step.

Using a double-side lapping machine and adequate abrasives (loose abrasive grains), the substrate laminate was lapped on the double sides to the desired thickness.

After the completion of double-side lapping, the substrate laminate 5ab was separated through heat treatment into two wafers. The wafers were ultrasonic cleaned in a selected chemical solution for removing the abrasives, particles and wax from the wafer surface.

After cleaning, the thickness of these wafers was measured by a probe thickness gauge, finding that the wafers were finished to a thickness of 120-130 µm, which was appropriate to work on the double-side polishing apparatus.

With the above results borne in mind, there were furnished a wafer (product substrate) 5a and a support substrate 5b which were twice lapped to a thickness of 120-130 µm as described above. These two wafers were laminated together, with their back surfaces (identical polarized surfaces) inside, using a wax Skyliquid TW-2511 (Nikka Seiko Co., Ltd.). Although a heat treatment is involved in the lamination step, this lamination ensures that the warpage of two wafers is offset because two wafers of the same material develop thermal expansion behavior in opposite directions. The laminate was ready for the subsequent polishing step.

Then the substrate laminate 5ab was mirror polished using a double-side polishing apparatus as shown in FIG. 2. Specifically, the substrate laminate 5ab was fitted in a hole (diameter 100.8 mm) of a polishing carrier 9. The carrier 9 having the substrate laminate 5ab received therein was disposed between a pair of lower and upper polishing platens 1 and 1' such that the surfaces to be polished were in contiguous contact with the abrasive cloths 2 and 2'. The lower and upper polishing platens 1 and 1' were then moved closer to apply a predetermined pressure. While abrasives of colloidal silica were fed to between the abrasive cloths 2 and 2', the platens 1 and 1' were rotated relatively. The polishing carrier 9 having the substrate laminate 5ab received therein was given planetary motion, thereby mirror polishing the laminate.

After the completion of mirror polishing, the substrate laminate 5ab was taken out of the hole 10 in the carrier 9 and separated through heat treatment into two wafers, wafer (product substrate) 5a and support substrate 5b. The wafers were ultrasonic cleaned at a certain frequency in a selected chemical solution for removing the abrasives of colloidal silica, particles and wax from the wafer surface.

After cleaning, the thickness of these wafers, wafer (product substrate) 5a and support substrate 5b was measured by a probe thickness gauge, finding that both wafer (product substrate) 5a and support substrate 5b were finished to a thickness of 90-100 µm. The back surfaces of these wafers, wafer (product substrate) 5a and support substrate 5b were visually observed under fluorescent lamps, finding no scratches. It is noted that since the wafer used as the support substrate 5b had been finished to a quality level comparable to the wafer (product substrate) 5a, it was equally handled as a product substrate.

By repeating the above-described procedure, 200 wafers were polished. The wafers (product substrates) 5a were measured for flatness, finding a total thickness variation (TTV) of 0.75 to 2.66 µm and a local thickness variation maximum (LTVₘₐₓ) of 0.20 to 0.39 µm at 5 mm × 5 mm site. No breakage occurred in the wafers during the single-side polishing operation, but breakage occurred in some wafers when the substrate laminate was separated into two wafers after the mirror polishing. The manufacturing yield was 97%.

### Comparative Example 1

This example relates to a lithium tantalate (LiTaO₃) single crystal wafer having a diameter of 100 mm (4 inches). A single crystal ingot was grown by Czochralski method and sliced into wafers using a wire saw. The wafers as sliced were lapped on a double-side lapping machine with appropriate abrasives (loose abrasive grains) to a desired thickness and until the front and back surfaces reached the predetermined roughness state.

Then a wafer lapped as above (having front and back surfaces roughened) was mirror polished using a single-side polishing apparatus as shown in FIG. 3. Specifically, a template 6 of glass-reinforced epoxy resin having holes punched out was secured to a ceramic plate 4 with double-side adhesive tape to define on the plate 4 recesses (punched holes) 7 for receiving wafers in place. The wafer as lapped (having front and back surfaces roughened) was suction gripped in the recess 7 via a back pad of polyurethane foam having a thickness of 0.4 mm. In this state, the plate 4 was placed on a platen 1 such that the surface to be polished was in contiguous contact with an abrasive cloth 2. Then a drive shaft 8 was slowly moved down until it came in contact with the plate 4. While abrasives of colloidal silica were fed onto the abrasive cloth 2, the shaft 8 was further moved down to apply some pressure and rotated slowly. The subsequent rotation at the predetermined rotational speed under the predetermined pressure achieved mirror polishing.

After the completion of mirror polishing, the wafer was taken out of the recess 7 in the ceramic plate 4. The wafer was ultrasonic cleaned at a certain frequency in a selected chemical solution for removing the abrasives of colloidal silica, particles and wax from the wafer surface.

After cleaning, the thickness of the wafer was measured by a probe thickness gauge, finding that the wafer was finished to a thickness of 90-100 µm. The back surface of the wafers was visually observed under fluorescent lamps, finding no scratches.

By repeating the above-described procedure, 100 wafers were polished. The wafers (product substrates) 5a were measured for flatness, finding a total thickness variation (TTV) of 3.24 to 4.07 µm and a local thickness variation maximum (LTVₘₐₓ) of 1.86 to 2.53 µm at 5 mm × 5 mm site. Many wafers popped out of the hole and thus broke during the single-side polishing operation. Also breakage occurred in many wafers when they were separated from the back pad after the mirror polishing. The manufacturing yield was 23%.

### Comparative Example 2

This example relates to a lithium tantalate (LiTaO₃) single crystal wafer having a diameter of 100 mm (4 inches). A single crystal ingot was grown by Czochralski method and sliced into wafers using a wire saw. The wafers as sliced were lapped on a double-side lapping machine with appropriate abrasives (loose abrasive grains) to a desired thickness and until the front and back surfaces reached the predetermined roughness state.

Then a wafer lapped as above (having front and back surfaces roughened) was mirror polished using a double-side polishing apparatus as shown in FIG. 2. Specifically, two wafers were laminated via an adsorbent plate. The sandwich was fitted in a hole 10 (diameter 100.8 mm) of a polishing carrier 9. The carrier 9 having the substrate sandwich received therein was disposed between a pair of lower and upper polishing platens 1 and 1' such that the surfaces to be polished were in contiguous contact with the abrasive cloths 2 and 2'. The lower and upper polishing platens 1 and 1' were then moved closer to apply a predetermined pressure. While abrasives of colloidal silica were fed to between the abrasive cloths 2 and 2', the platens 1 and 1' were rotated relatively. The polishing carrier 9 having the substrate sandwich received therein was given planetary motion, thereby mirror polishing the laminate.

After the completion of mirror polishing, the sandwich was taken out of the hole 10 in the carrier 9. The wafers were ultrasonic cleaned at a certain frequency in a selected chemical solution for removing the abrasives of colloidal silica and particles from the wafer surface.

After cleaning, the thickness of the wafers was measured by a probe thickness gauge, finding that the wafers were finished to a thickness of 90-100 µm. The back surface of the wafers was visually observed under fluorescent lamps, finding scratches on the back surface of some wafers.

By repeating the above-described procedure, 200 wafers were polished. The wafers (product substrates) 5a were measured for flatness, finding a total thickness variation (TTV) of 0.88 to 2.23 µm and a local thickness variation maximum (LTVₘₐₓ) of 0.20 to 0.41 µm at 5 mm × 5 mm site. Many wafers popped out of the hole 10 in the carrier 9 and thus broke during the double-side polishing operation. Also breakage occurred in many wafers when they were separated after the mirror polishing. The manufacturing yield was 35%.

It is demonstrated that as compared with Comparative Examples, Examples are successful in manufacturing in high yields thin wafers having a thickness equal to or less than 100 µm. Such thin wafers can be produced in a consistent manner at an improved working accuracy such as high flatness or parallelism equivalent to that of the existing 350-µm thick wafers while maintaining their front and back surface states equivalent to those of the existing 350-µm thick wafers.

Although lithium tantalate wafers having a diameter of 100 mm (4 inches) are referred to in Examples, the invention is equally applicable to piezoelectric oxide single crystal wafers of lithium tantalate, lithium niobate, quartz, lithium tetraborate, langasite and the like used in SAW filers or the like. The thickness and diameter of wafers are not particularly limited.

## Claims

1. A method of polishing a piezoelectric oxide single crystal wafer substrate (5a), having a diameter D mm, comprising the steps of:
laminating a support substrate (5b), of the same material as the wafer substrate (5a) and having a diameter of from D mm to (D + 2.5) mm, to the wafer substrate (5a) to form a substrate laminate (5ab), the wafer and support substrates (5a,5b) having polarised surfaces, and being laminated with their identically polarised surfaces in contiguous contact;
fitting the substrate laminate (5ab) in a punched hole (7) of a template (6) secured to a plate (4), the punched hole (7) having a diameter from D mm to (D + 5.0) mm, with the substrate (5a) between the plate (4) and an abrasive cloth (2) on a polishing platen (1);
relatively rotating said polishing platen (1) and said plate (4) to mirror-polish the cloth-side surface of the wafer substrate (5a) with the abrasive cloth (2), and
feeding a liquid onto the plate-side surface of the substrate laminate (5ab) so that it is directly held to the plate (4) by the adsorption force of the liquid, while performing the mirror polishing.

2. A method of polishing a piezoelectric oxide single crystal wafer substrate (5a), having a diameter D mm, comprising the steps of:
laminating a support substrate (5b), of the same material as the wafer substrate (5a) and having a diameter from D mm to (D + 2.5) mm to the wafer substrate (5a) to form a substrate laminate (5ab), the wafer and support substrates (5a,5b) having polarised surfaces, and being laminated with their identically polarised surfaces in contiguous contact;
fitting the substrate laminate (5ab) within a punched hole (10) of a polishing carrier (9), the punched hole (10) of the carrier (9) having a diameter of from D mm to (D + 5.0) mm and the polishing carrier (9) being disposed between abrasive cloths (2,2') on a pair of upper and lower polishing platens (1,1'), and
relatively rotating the polishing platens (1,1') to mirror-polish the outer surfaces of the wafer substrate (5a) and the support substrate (5b) in the laminate (5ab) .

3. A method according to claim 1 or 2 in which the back surface of the wafer substrate (5a) is roughened before lamination to the support substrate (5b).

4. A method according to any one of claims 1 to 3 in which the wafer substrate (5a) and the support substrate (5b) are laminated using wax or pressure-sensitive adhesive to form the substrate laminate (5ab).

5. A method of any one of the preceding claims wherein the piezoelectric oxide single crystal is lithium tantalate.

6. A method of any one of the preceding claims wherein the polished wafer substrate (5a) has a thickness of up to 100 µm.

7. A method of any one of the preceding claims followed by using the polished wafer substrate (5a) to make a surface acoustic wave filter.

## Patentansprüche

1. Verfahren zum Polieren eines piezoelektrischen Oxideinkristallwafersubstrats (5a) mit einem Durchmesser von D mm, umfassend folgende Schritte:
Laminieren eines Trägersubstrats (5b), das aus demselben Material wie das Wafersubstrat (5a) besteht und einen Durchmesser von D mm bis (D + 2,5) mm aufweist, auf das Wafersubstrat (5a), um ein Substratlaminat (5ab) zu bilden, wobei das Wafersubstrat und das Trägersubstrat (5a, 5b) polarisierte Oberflächen aufweisen und so laminiert sind, dass ihre identisch polarisierten Oberflächen einander direkt kontaktieren;
Einbringen des Substratlaminats (5ab) in ein gestanztes Loch (7) einer Matrize (6), die an einer Platte (4) befestigt ist, wobei das gestanzte Loch (7) einen Durchmesser von D mm bis (D + 5,0) mm aufweist, wobei das Substrat (5a) zwischen der Platte (4) und einem Schleiftuch (2) auf einer Polierplatte (1) angeordnet ist;
Rotieren der Polierplatte (1) und der Platte (4) relativ zueinander, um die Oberfläche des Wafersubstrats (5a) auf der Seite des Tuchs mit dem Schleiftuch (2) auf Hochglanz zu polieren;
Zuführen einer Flüssigkeit auf die Oberfläche des Substratlaminats (4) auf de Seite der Platte, sodass dieses durch die Adsorptionskraft der Flüssigkeit direkt auf der Platte (4) gehalten wird, während das Hochglanzpolieren durchgeführt wird.

2. Verfahren zum Polieren eines piezoelektrischen Oxideinkristallwafersubstrats (5a) mit einem Durchmesser D, umfassend folgende Schritte:
Laminieren eines Trägersubstrats (5b), das aus demselben Material wie das Wafersubstrat (5a) besteht und einen Durchmesser von D mm bis (D + 2,5) mm aufweist, auf das Wafersubstrat (5a), um ein Substratlaminat (5ab) zu bilden, wobei das Wafersubstrat und das Trägersubstrat (5a, 5b) polarisierte Oberflächen aufweisen und so laminiert sind, dass ihre identisch polarisierten Oberflächen einander direkt kontaktieren;
Einbringen des Substratlaminats (5ab) in ein gestanztes Loch (10) eines Polierträgers (9), wobei das gestanzte Loch (10) des Trägers (9) einen Durchmesser von D mm bis (D + 5,0) mm aufweist und der Polierträger (9) zwischen Schleiftüchern (2, 2') und einem Paar Polierplatten bestehend aus einer oberen und einer unteren Polierplatte (1, 1') angeordnet ist, und
Rotieren der Polierplatten (1, 1') relativ zueinander, um die Außenoberflächen des Wafersubstrats (5a) und des Trägersubstrats (5b) in dem Laminat (5ab) auf Hochglanz zu polieren.

3. Verfahren nach Anspruch 1 oder 2, worin die hintere Oberfläche des Wafersubstrats (5a) vor dem Laminieren auf das Trägersubstrat (5b) aufgeraut wird.

4. Verfahren nach einem der Ansprüche 1 bis 3, worin das Wafersubstrat (5a) und das Trägersubstrat (5b) unter Verwendung von Wachs oder Haftklebstoff zur Bildung des Substratlaminats (5ab) laminiert werden.

5. Verfahren nach einem der vorangegangenen Ansprüche, worin der piezoelektrische Oxideinkristall Lithiumtantalat ist.

6. Verfahren nach einem der vorangegangenen Ansprüche, worin das polierte Wafersubstrat (5a) eine Dicke von bis zu 100 µm aufweist.

7. Verfahren nach einem der vorangegangenen Ansprüche, wonach das polierte Wafersubstrat (5a) verwendet wird, um ein akustisches Oberflächenfilter herzustellen.

## Revendications

1. Procédé de polissage d'un substrat de plaquette en monocristal d'oxyde piézoélectrique (5a), d'un diamètre D mm, comprenant les étapes de:
laminer un substrat de support (5b), du même matériau que le substrat de plaquette (5a) et d'un diamètre de D mm à (D + 2,5) mm, sur le substrat de plaquette (5a) pour former un laminé de substrat (5ab), les substrats de plaquette et de support (5a, 5b) ayant des surfaces polarisées, et étant laminées avec leurs surfaces polarisées de manière identique en contact contigu;
insérer le laminé de substrat (5a, 5b) dans un trou découpé (7) d'un gabarit (6) fixé à une plaque (4), le trou découpé (7) ayant un diamètre de D mm à (D + 5, 0) mm, avec le substrat (5a) entre la plaque (4) et un tissu abrasif (2) sur une plaque de polissage (1);
faire tourner relativement ladite plaque de polissage (1) et ladite plaque (4) en vue d'un polissage miroir de la surface côté tissu du substrat de plaquette (5a) avec le tissu abrasif (2), et
amener un liquide sur la surface côté plaque du laminé de substrat (5a, 5b) de sorte qu'il est directement retenu sur la plaque (4) par la force d'adsorption du liquide, tout en exécutant le polissage miroir.

2. Procédé de polissage d'un substrat de plaquette en monocristal d'oxyde piézoélectrique (5a), d'un diamètre D mm, comprenant les étapes de:
laminer un substrat de support (5b) du même matériau que le substrat de plaquette (5a) et ayant un diamètre de D mm à (D + 2,5) mm sur le substrat de plaquette (5a) pour former le laminé de substrat (5ab), les substrats de plaquette et de support (5a, 5b) ayant des surfaces polarisées et étant laminées avec leurs surfaces polarisées d'une manière identique en contact contigu;
insérer le laminé de substrat (5a, 5b) dans un trou découpé (10) d'un support de polissage (9), le trou découpé (10) du support (9) ayant un diamètre de D mm à (D + 5,0) mm, et le support de polissage (9) étant disposé entre des tissus abrasifs (2, 2') sur une paire de plaques de polissage supérieure et inférieure (1, 1'), et
faire tourner relativement les plaques de polissage (1, 1') pour un polissage miroir des surfaces extérieures du substrat de plaquette (5a) et du substrat de support (5b) dans le laminé (5ab) .

3. Procédé selon la revendication 1 ou 2, dans lequel la surface arrière du substrat de plaquette (5a) est rendue rugueuse avant la lamination au substrat de support (5b).

4. Procédé selon l'une quelconque des revendications 1 à 3, dans lequel le substrat de plaquette (5a) et le substrat de support (5b) sont laminés en utilisant de la cire ou un adhésif réagissant à la pression pour former le laminé de substrat (5a, 5b).

5. Procédé selon l'une quelconque des revendications précédentes, dans lequel le monocristal d'oxyde piézoélectrique est du lithium tantalate.

6. Procédé selon l'une quelconque des revendications précédentes, dans lequel le substrat de plaquette poli (5a) a une épaisseur jusqu'à 100 µm.

7. Procédé selon l'une quelconque des revendications précédentes, suivi de l'utilisation du substrat de plaquette poli (5a) pour réaliser un filtre d'ondes acoustiques de surface.
